## Europäisches Patentamt

(19) **European Patent Office**

**Office européen des brevets**

(11) Publication number: **0 076 104**
**B1**

(12) **EUROPEAN PATENT SPECIFICATION**

(45) Date of publication of patent specification: **28.06.89**

(21) Application number: **82305022.4**

(22) Date of filing: **23.09.82**

(51) Int. Cl.⁴: **H 01 L 21/50, H 01 L 23/10**

(54) Package for semicondutor device and method of manufacturing it.

| | |
|---|---|
| (30) Priority: **30.09.81 JP 153892/81** | (73) Proprietor: **FUJITSU LIMITED**<br>**1015, Kamikodanaka Nakahara-ku**<br>**Kawasaki-shi Kanagawa 211 (JP)** |
| (43) Date of publication of application:<br>**06.04.83 Bulletin 83/14** | (72) Inventor: **Watanabe, Hisashi**<br>**2646-5, Eda-cho Midori-ku**<br>**Yokohama-shi Kanagawa 227 (JP)** |
| (45) Publication of the grant of the patent:<br>**28.06.89 Bulletin 89/26** | |
| (84) Designated Contracting States:<br>**DE FR GB** | (74) Representative: **Skone James, Robert Edmund**<br>**et al**<br>**GILL JENNINGS & EVERY 53-64 Chancery Lane**<br>**London WC2A 1HN (GB)** |
| (56) References cited:<br>**US-A-3 190 952**<br><br>**TOUTE L'ELECTRONIQUE, no. 475, June/July**<br>**1982, pages 29-32, Stevenage, Herts, GB,**<br>**Editeur: Société des Editions Radio, 75006**<br>**Paris, FR; M. LEBAILLY: "Les technologies**<br>**d'encapsulation"** | |

Courier Press, Leamington Spa, England.

## Description

The present invention relates to a method of manufacturing a package for a semiconductor device.

For the purpose of protecting a semiconductor element from mechanical impact and the atmosphere, a package made of, for example, alumina ceramic, is provided. Typically the package comprises a package substrate; a sealing frame mounted to the package substrate; a semiconductor element mounted on the package substrate; and a sealing cap seam welded to the sealing frame the semiconductor element being sealed by the sealing frame and the sealing cap. Often a good airtight seal is not achieved due to difficulties in seam welding and sealing cap to the sealing frame.

US—A—3190952 illustrates the construction of a hermetically sealed container for a transistor or other device in which a cap is welded to the projecting portion of a sealing frame mounted on a package substrate. After welding, extraneous parts of the flanged sealing frame are removed by swinging the flanges about a weakened line adjacent the weld. This can damage the weld region.

In accordance with the present invention, a method of manufacturing a package for a semiconductor device comprises providing a sealing frame on a package substrate; mounting a semiconductor element on the substrate; and seam welding a sealing cap to the sealing frame to seal the semiconductor element, wherein the sealing frame is provided with a projecting portion on one side and a droop portion on the other side during formation of the frame by blanking or presswork prior to the seam welding step and characterised in that the projecting portion is welded to said sealing cap, which said side of the sealing frame with the droop portion contacts the package substrate.

By providing a projecting portion the contact resistance welding can be carried out and so unnecessary heating of portions other than the required welding portion can be avoided.

Furthermore, the projecting portion provided on the sealing frame prevents slippage of the sealing cap when the sealing cap is seam welded to the sealing frame.

Preferably, the or each projecting portion comprises a flash or burr produced during manufacture of the one or the sealing cap and the sealing frame of which it forms part.

In addition, it is advantageous if the or each projecting portion forms a line contact with the one of the sealing frame and the sealing cap of which it forms part.

Furthermore, it is preferable if the or each projecting portion projects from a surface of the one of the sealing cap and the sealing frame of which it forms part by a distance within the range of 20 to 30 μm.

Some examples of methods in accordance with the present invention will now be described and contrasted with the prior art with reference to the accompanying drawings, in which:

Figure 1 is a perspective view of a partially completed conventional package; Figure 2 is a schematic cross-sectional view taken on the line A—A in Figure 1 showing additionally a sealing cap and welding electrodes;

Figure 3 is a partially enlarged schematic cross-sectional view illustrating a conventional embodiment; and Figures 4 to 6 are views similar to Figure 3 but of examples in accordance with the invention.

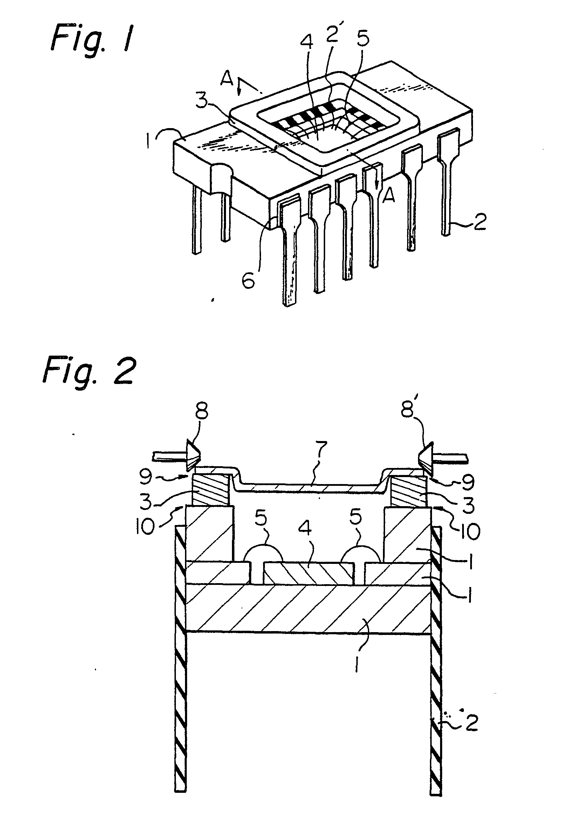

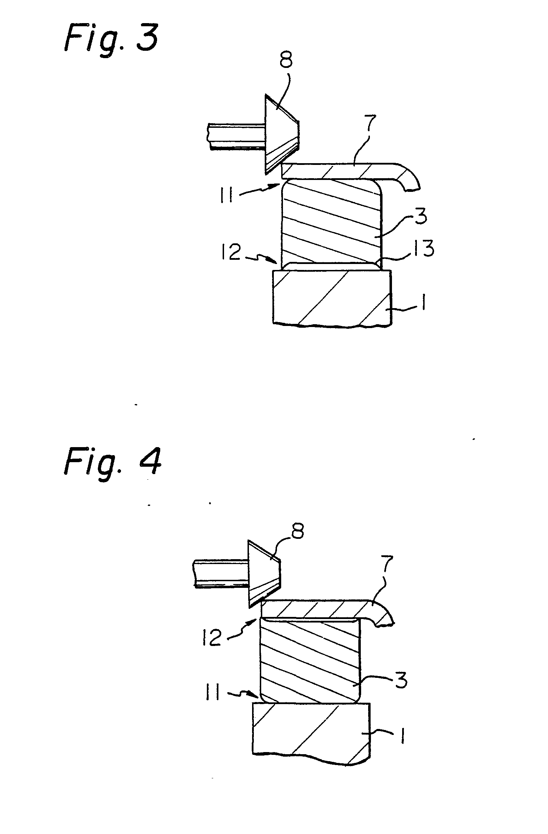

As shown in Figure 1 and Figure 2, a sealing frame 3 is provided on a surface of a package substrate 1 made of ceramic. On the inner side of the package substrate 1, a semiconductor element 4 is fixed to the surface of the package substrate 1, and the semiconductor element is electrically connected to an outer lead 2 through lead wire 5 and inner conductive patterns 2'. After provision of the semiconductor element 4, the lead wire 5 and the inner conductive patterns 2' are provided as mentioned above, and the sealing frame 3, which is made of, for example, KOVAR, and which is preliminarily fixed to the package substrate 2 by silver soldering, etc is sealed with a sealing cap 7 (Figure 2) made of, for example, KOVAR, by welding. Conventionally, the process of welding the sealing cap 7 to the sealing frame 3 is a parallel seam welding wherein, as shown in Figure 2, conical electrodes 8, 8' are rolled while contacting both edges of the sealing cap 7. Seam welding is carried out by using heat which is produced by flowing a current between electrodes 8 and 8' at the contact portion of the sealing cap 7 and the sealing frame 3. The sealing frame 3, which is welded with the sealing cap 7, is usually obtained by blanking or presswork. As shown in Figure 3, the sealing frame 3 produced by blanking or presswork has droops 11 and flashes 12, the shape of the flash 12 being a characteristic one produced by blanking or presswork.

Conventionally, in the seam welding of the sealing cap 7 to the sealing frame 3, the seam welding is carried out so that the side of the frame 3 having the droop portion 11 is welded to the sealing cap 7.

In such seam welding, since the upper surface of the sealing frame has the droop portion 11, a gap is formed between the edges of the sealing frame 3 and the sealing cap 7. Further, in the seam welding, the contact of the sealing frame 3 with the sealing cap 7 is an entire surface contact. Therefore, since the heating value per unit area is decreased, it is difficult to increase the temperature to the required temperature for the welding and, thus, the weldability of the sealing frame 3 to the sealing cap 7 is lowered. On the other hand, when the applied electric power is increased to improve the weldability, the package substrate 1 sometimes cracks due to the heat transmitted from the sealing frame 3.

As shown in Figure 3, the side to be soldered in the sealing frame 3 might have a gap between the surface of the sealing frame 3 and the package substrate 1 due to the flash 12 produced by blanking or presswork. Thus, a problem in the sealing effect between the sealing frame 3 and the package substrate 1 can occur.

Referring to Figure 4, on the package substrate 1, the sealing frame 3 is provided.

The sealing frame 3 is provided by blanking or presswork. Therefore, the sealing frame 3 has flashes projecting for example, 25 µm from the substantially horizontal surface thereof on one side of it and has droop portions 11 on the other side of it, being a usual frame produced by blanking or presswork.

In the sealing frame 3 illustrated in Figure 4, the side having droop portions 11 contacts the package substrate while the side having flashes 12 contacts the sealing cap 7. Teh seam welding is carried out by means of the electrodes 8 so that the edge portion of the sealing cap 7 is welded to the flash portion having a curved surface which is produced substantially at the edge of the sealing frame 3, with the result that the contact of the curved surface of the flash portion of the sealing frame 3 with the edge portion of the sealing cap 7 is changed to a line contact from a surface contact in the prior art.

Thus, the heat value per unit area is increased and it is easy to increase the temperature up to the required temperature for the seam welding. Further, when the flash portion 12 is seam welded as shown in Figure 4, the gap produced by the droop portions 11 shown in Figure 3 is not formed in the structure shown in Figure 4. Additionally, since a gap 13, illustrated in Figure 3, cannot be formed between the package substrate 1 and the sealing frame 3 in Figure 4, airtightness between the package substrate 1 and the sealing frame 3 can be improved. The package substrate 1 is made of, for example, alumina ceramic.

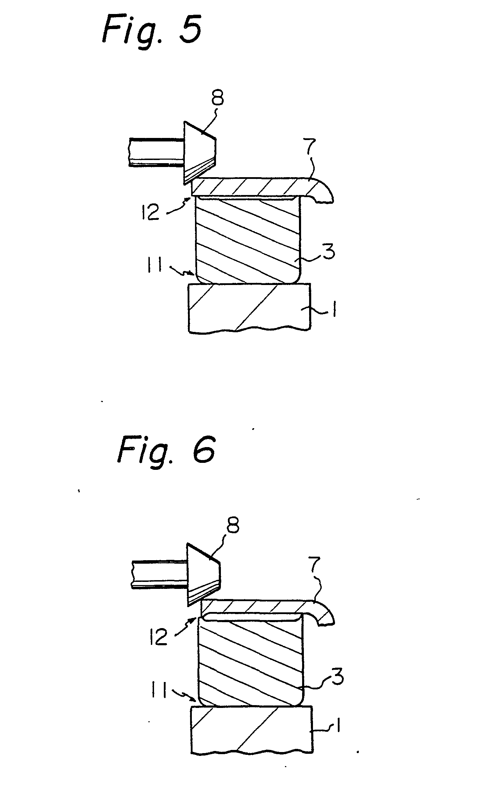

In Figure 5, the sealing cap 7 completely covers the flash portion 12. When such a condition exists, seam welding can also be carried out.

Instead of just forming a projecting portion 12 on the sealing frame 3, it may be advantageous to form another projecting portion of the sealing cap 7, on an edge portion thereof, to be welded as shown in Figure 6. The projecting portion of the sealing cap 7 may be a flash or a burr produced by presswork.

## Claims

1. A method of manufacturing a package for a semiconductor device, the method comprising providing a sealing frame (3) on a package substrate (1); mounting a semiconductor element (4) on the substrate (1); and seam welding a sealing cap (7) to the sealing frame (3) to seal the semiconductor element (4), wherein the sealing frame (3) is provided with a projecting portion (12) on one side and a droop portion (11) on the other side during·formation of the frame by blanking or presswork prior to the seam welding step characterised in that said projecting portion (12) is welded to the sealing cap (7) while said side of the sealing frame with the droop portion contact the package substrate (1).

2. A method according to claim 1, wherein the sealing cap (7) has a projecting portion which contracts the sealing frame (3).

3. A method according to claim 1 or claim 2, wherein the or each projecting portion (12) projects from a surface of the one of the sealing cap (7) and the sealing frame (3) of which it forms part by a distance within the range of 20 to 30 µm.

4. A method according to any of the preceding claims, wherein the or each projecting portion (12) forms a line contact with the one of the sealing frame (3) and the sealing cap (7) of which it forms part.

5. A method according to any of the preceding claims, wherein the or each projecting portion (12) comprises a flash or burr produced during manufacutre of the one of the sealing cap (7) and the sealing frame (3) of which is forms part.

6. A method according to any of the preceding claims, wherein the or each projecting portion (12) is at an edge portion of the one of the sealing cap (7) and the sealing frame (3) on which it is provided.

## Patentansprüche

1. Verfahren zur Herstellung einer Packung für eine Halbleitervorrichtung, bei welchem Verfahren ein Dichtungsrahmen (3) auf einem Packungssubstrat (1) vorgesehen wird; ein Halbleiterelement (4) auf dem Substrat (1) montiert wird; und ein Verschlußdeckel (7) an den Dichtrahmen (3) angeschweißt wird, um das Halbleiterelement (4) zu versiegeln, wobei der Dichtrahmen (3), während der Bildung des Rahmens durch Schneiden oder Pressen vor dem Nahtschwießungsschritt mit einem vorstehenden Abschnitt (12) auf einer Seite und einen abfallenden Abschnitt (11) auf der anderen Seite versehen wird, dadurch gekennzeichnet, daß der genannte vorstehende Abschnitt (12) an den Verschlußdeckel (7) angeschweißt wird, während die genannte Seite des Dichtrahmens mit dem abfallenden Abschnitt das Packungssubstrat (1) kontaktiert.

2. Verfahren nach Anspruch 1, bei dem der Verschlußdeckel (7) einen vorstehenden Abschnitt hat, der den Dichtrahmen (3) kontaktiert.

3. Verfahren nach Anspruch 1 oder 2, bei dem der oder jeder vorstehende Abschnitt (12) von einer Oberfläche von einem von dem Verschlußdeckel (7) oder dem Dichtrahmen (3), von welchem er einen Teil bildet, um einen Abstand in einem Bereich von 20 bis 30 µm vorsteht.

4. Verfahren nach einem der vorhergehenden Ansprüche, bei dem der oder jeder vorstehende Abschnitt (12) einen Linienkontakt mit einen von dem Dichtrahmen (3) und dem Verschlußdeckel (7) bildet, von welchem er einen Teil bildet.

5. Verfahren nach einem der vorhergehenden Ansprüche, bei dem der oder jeder vorstehende Abschnitt (12) einen Kragen oder Grat hat, der während der Herstellung von einen von dem Verschlußdeckel (7) und dem Dichtrahmen (3), von welchem er einen Teil bildet, erzeugt wurde.

6. Verfahren nach einem der vorhergehenden Ansprüche, bei dem der oder jeder vorstehende Abschnitt (12) sich an einem Randabschnitt von einem vom dem Verschlußdeckel (7) und dem Dichtrahmens (3), and welchem er vorgesehen ist, befindet.

**Revendications**

1. Méthode de fabrication d'un emballage pour un dispositif semiconducteur, dans laquelle on agence un cadre de scellement (3) sur un substrat d'emballage (1); on monte un élément semiconducteur (4) sur le substrat (1); et l'on soude, par soudage à la molette, un couvercle d'obturation étanche (7) sur le cadre de scellement (3), pour sceller l'élément semiconducteur (4), le cadre de scellement (3) étant pourvu d'un côté d'une partie saillante (12) et de l'autre côté d'une partie abattue (11), au cours de la formation du cadre par découpage ou travail à la presse, avant l'étape de soudage à la molette, caractérisée en ce qu'on soude ladite partie saillante (12) au couvercle d'obturation étanche (7), alors que ladit côté du cadre de scellement doté de la partie abattue est au contact du substrat d'emballage (1).

2. Méthode selon revendication 1, dans laquelle le couvercle d'obturation étanche (7) comporte une partie saillante que est au contact du cadre de scellement (3).

3. Méthode selon revendication 1 ou revendication 2, dans laquelle la partie saillante, ou chaque partie saillante (12), forme saillie depuis une surface du couvercle d'obturation étanche (7) ou du cadre se scellement (3), selon celui des deux auquel elle appartient, la saillie formée étant comprise dans la plage de 20 à 30 µm.

4. Méthode selon l'une quelconque des revendications précédentes, dans laquelle la partie saillante, ou chaque partie saillante (12), forme un contact linéaire avec le cadre de scellement (3) ou le couvercle d'obturation étanche (7), selon celui de ceux-ci auquel elle appartient.

5. Méthode selon l'une quelconque des revendications précédentes, dans laquelle la partie saillante, ou chaque partie saillante (12), comprend une arête saillante ou bavure produite au cours de la fabrication du couvercle d'obturation étanche (7) ou du cadre de scellemen (3), selon celui de ceux-ci auquel elle appartient.

6. Méthode selon l'une quelconque des revendications précédentes, dans laquelle la partie saillante, ou chaque partie saillante (12), est une partie formant arête du couvercle d'obturation étanche (7) et/ou du cadre de scellement (3), selon qu'elle est prévue sur l'un ou l'autre de ceux-ci.

*Fig. I*

*Fig. 2*

1

*Fig. 3*

*Fig. 4*

## Fig. 5

## Fig. 6